# EUROPEAN PATENT SPECIFICATION

(11) **EP 2 863 720 B1**
(45) Date of publication and mention of the grant of the patent: **26.11.2025**
(21) Application number: 14189058.2
(22) Date of filing: 15.10.2014
(51) Int. Cl.: H05K 1/09, H05K 3/26, H05K 1/03, H05K 3/12, H05B 3/26

(54) **DIRECT WRITING BUS BARS FOR SCREEN PRINTED RESIN-BASED CONDUCTIVE INKS**
Direktschreibende Sammelschienen für siebgedruckte leitfähige Tinten auf Harzbasis
Barres de bus d'écriture directe pour des encres conductrices à base de résine imprimée par sérigraphie

(30) Priority: 15.10.2013 US 201361891276 P; 15.10.2013 US 201361891292 P; 27.02.2014 US 201414191873
(43) Date of publication of application: 22.04.2015
(73) Proprietor: Goodrich Corporation, Charlotte, NC 28217-4578 (US)
(72) Inventor: HU, Jin, Hudson, OH 44236 (US)
(74) Representative: Dehns

(56) References cited:
- EP-A1- 2 258 143
- EP-A2- 0 347 824
- EP-A2- 2 113 456
- DE-A1- 102011 084 303
- DE-A1- 3 919 974
- US-A1- 2004 100 131

## Description

The present disclosure relates to heating circuits, and more particularly to screen printed resin-based conductive ink circuits.

Resin-based conductive ink can be screen printed in a variety of circuit configurations, for example for resistive heater circuits. One challenge with traditional screen printed resin-based conductive ink circuits is that resin-based conductive ink cannot directly solder for a wire connection. In traditional screen printed resin-based conductive ink circuits, metal and/or alloy bus bars, e.g. copper bus bars, are bonded to the screen printed resin-based conductive ink by using conductive adhesive for subsequent soldering to a wire connection.

In traditional screen printed resin-based conductive ink circuits where bus bars are attached with conductive adhesives, subsequent curing of the adhesive is required. This curing requires specialized surface treatments and adhesive handling. The robustness of bus bar attachments can be compromised if the manufacture workers are not experienced in such treatments or adhesive handling.

DE 3919974 A1 discloses an article comprising a vitreous substrate bearing electric circuit means. US 2004/100131 A1 discloses printing a conductive circuit for an aircraft floor panel.

Such conventional methods and systems have generally been considered satisfactory for their intended purpose. However, there is still a need in the art for systems and methods that allow for improved adhesion of bus bars to screen printed resin-based conductive inks. The present disclosure provides a solution for these problems.

In accordance with the present disclosure, a method for providing an electrical connection for conductive ink is provided in claim 1.

In certain embodiments, the conductive ink can include silver particles in an epoxy resin on a dielectric film. Further, the method can include soldering a wire to the bus bar to electrically connect the wire to the conductive ink. In addition, the method can include applying the conductive circuit to at least one panel skin of an aircraft floor panel. The bus bar can be a metal, e.g. copper, bus bar, and/or and alloy bus bar.

Whilst not claimed *per se,* a heated floor panel is also described herein, comprising: at least one floor panel of an aircraft including a conductive circuit having a conductive ink that has been screen printed onto a dielectric film to create a conductive circuit, wherein the at least one floor panel includes a bus bar that has been directly written onto areas of a desired electrical connection for the conductive ink, and the bus bar forms a conformal layer of bus bar on the conductive ink.

It is also contemplated that a wire can be soldered onto the bus bar to electrically connect the wire and the conductive circuit. Also, the conductive ink can include silver particles in an epoxy resin on a dielectric film.

These and other features of the systems and methods of the subject disclosure will become more readily apparent to those skilled in the art from the following detailed description of the preferred embodiments taken in conjunction with the drawings.

So that those skilled in the art to which the subject disclosure appertains will readily understand how to make and use the devices and methods of the subject disclosure without undue experimentation, preferred embodiments thereof will be described in detail herein below by way of example only and with reference to certain figures, wherein:
Fig. 1 is a top plan view of an exemplary embodiment of a screen printed conductive ink circuit constructed in accordance with a preferred embodiment of the present disclosure, schematically showing the bus bar, conductive ink, and soldered wire connection;
Fig. 2 is a partial side elevation view of the screen printed conductive ink circuit of Fig. 1, schematically showing the bus bar, conductive ink and soldered wire connection;
Fig. 3 is a top plan view of the screen printed conductive ink circuit of Fig. 1, schematically showing the conductive ink circuit with the bus bar on an aircraft heated floor panel;
Fig. 4 is a top plan view of an exemplary embodiment of a screen printed conductive ink circuit constructed in accordance with a preferred embodiment of the present disclosure, schematically showing the bus bar, conductive ink, and soldered wire connection; and
Fig. 5 is a partial side elevation view of the screen printed conductive ink circuit of Fig. 4, schematically showing the bus bar, conductive ink and soldered wire connection.

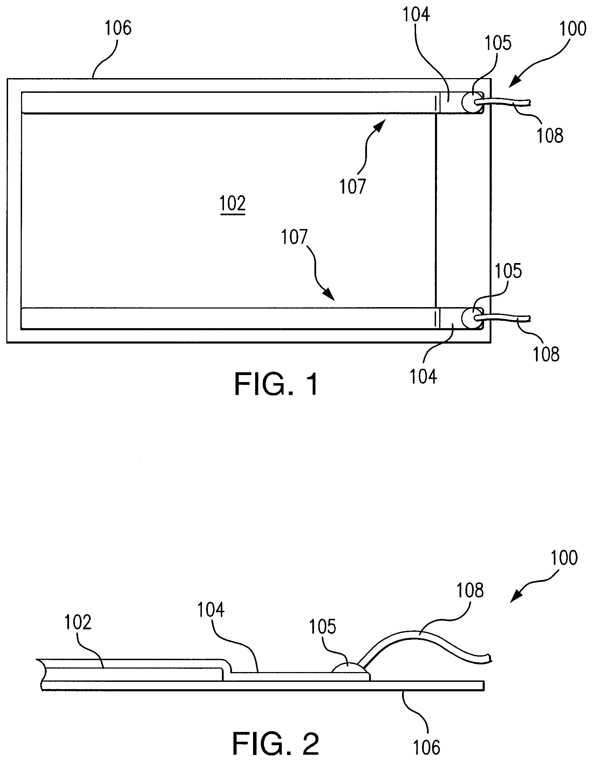

Reference will now be made to the drawings wherein like reference numerals identify similar structural features or aspects of the subject disclosure. For purposes of explanation and illustration, and not limitation, an exemplary embodiment of a conductive ink circuit with a bus bar constructed in accordance with the disclosure is shown schematically in Fig. 1 and is designated generally by reference character 100. Other embodiments of conductive ink circuits with a bus bar in accordance with preferred embodiments of the disclosure, or aspects thereof, are provided schematically in Figs. 2-5, as will be described. The systems and methods described herein can be used to bond bus bars, e.g. copper bus bars, by direct writing copper buses on wire connection areas of screen printed conductive ink circuits.

As shown schematically in Figs. 1 and 2, a conductive ink circuit 100 includes conductive ink 102 and bus bars 104, e.g. copper bus bars. Conductive ink 102 is screen printed in a pattern onto a dielectric film 106 to create conductive ink circuit 100, wherein the conductive ink 102 forms an electrical resistive heating element. For example, conductive ink 102 can have perforations, or any other suitable pattern. Each copper bus bar 104 is connected to a respective wire 108 by solder 105. Copper bus bars 104 electrically connect their respective wires 108 to conductive ink 102. While described herein as copper bus bars 104, those skilled in the art will readily appreciate that bus bars 104 can be made from a variety of metals and/or alloys.

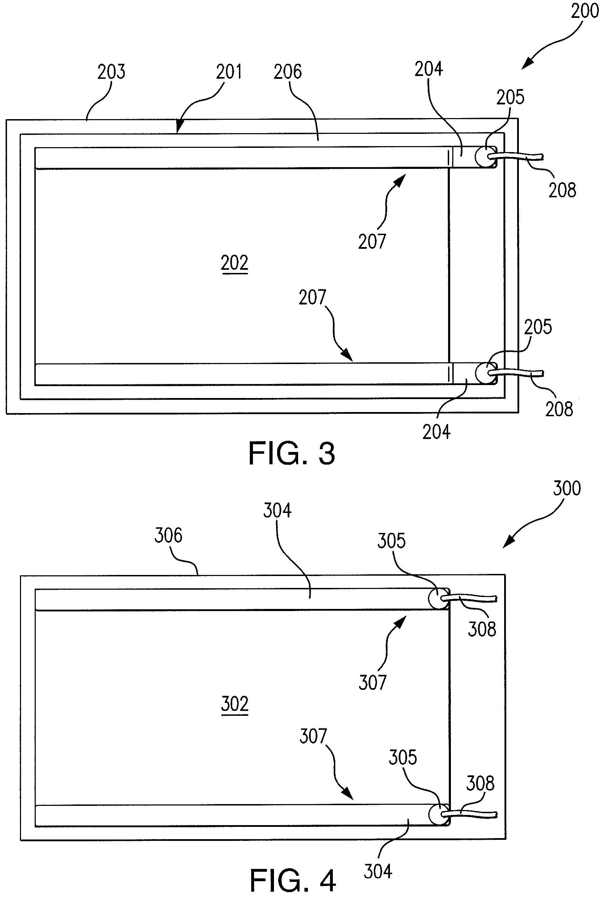

As shown schematically in Fig. 3, an aircraft heated floor panel 200 includes at least one floor panel 203 of an aircraft. Floor panel 203 includes a conductive circuit 201 having a conductive ink 202 including copper bus bars 204 directly written onto areas of a desired electrical connection 207 of conductive ink 202, as described above. Conductive ink 202 is screen printed onto a dielectric film 206 to create conductive circuit 201. Solder 205 connects a wire 208 onto each respective copper bus bar 204 to electrically connect each wire 208 and conductive circuit 201. Conductive ink 202 can include silver particles in an epoxy resin on dielectric film 206.

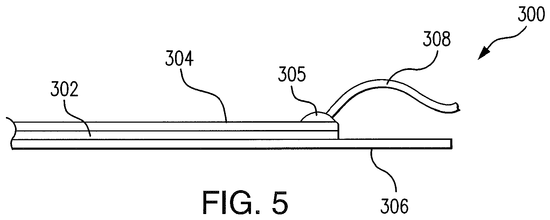

As shown schematically in Figs. 4 and 5, a conductive ink circuit 300 includes conductive ink 302 and copper bus bars 304. Conductive ink circuit 300 is substantially similar to conductive ink circuit 100 except that copper bus bars 304 are only applied to conductive ink 302, instead of conductive ink 302 and dielectric film 306. Applying copper bus bars 304 only to conductive ink 302 can tend to save space in compact applications. For example, in applications where there may be multiple conductive ink circuits 300 and/or multiple copper bus bars 304.

A method for soldering an electrical connection onto a conductive ink, e.g. conductive ink 102, 202 or 302, includes direct writing alloy and/or metal bus bars, e.g. copper bus bars 104, 204 or 304, onto areas of a desired electrical connection, e.g. desired electrical connection areas 107, 207 or 307, of the conductive ink. The step of direct writing includes forming a conformal layer of the copper bus bars on the conductive ink. The conductive ink can include silver particles in an epoxy resin. Further, the method for soldering an electrical connection onto the conductive ink can include soldering a wire, e.g. wire 108, 208 or 308, to each respective copper bus bar to electrically connect the wires to the conductive ink. The method for soldering an electrical connection onto the conductive ink can also include applying a conductive circuit, e.g. conductive circuit 100, 200 or 300, to at least one panel skin of an aircraft floor panel, e.g. floor panel 203, described above.

MesoPlasma^{™} thermal spray, available from MesoScribe Technologies, Inc., 7 Flowerfield, Suite 28, St. James, New York, can be used to direct write alloy and/or metal bus bars, e.g. copper bus bars 104, 204 or 304, on wire connection areas, e.g. desired electrical connection areas 107, 207 or 307, of conductive ink circuits, e.g. conductive ink circuits 100, 200 or 300, for wire connections. MesoPlasma^{™} thermal spray can also write alloy and/or metal traces, e.g. copper bus bars 104, 204 or 304, on plastic without adhesives and no curing is required, reducing labor time and cost as compared to traditional conductive ink circuits. It is contemplated that any other suitable direct write technology can also be used to direct write metal bus bars, e.g. copper bus bars, on wire connection areas, for example, Aerosol Jet^{®} printing, available from Optomec, Inc. Corporation, 3911 Singer Boulevard, N.E. Albuquerque, New Mexico, can be used.

The methods and systems of the present disclosure, as described above and shown in the drawings, provide for conductive ink circuits with copper bus bars with superior properties including ease of manufacturing.

## Claims

1. A method for providing an electrical connection (107; 207; 307) for conductive ink that has been screen printed onto a dielectric film (106; 206; 306) to create a conductive circuit for an aircraft floor panel (200), the method comprising:
direct writing a bus bar (104; 204; 304) onto areas of a desired electrical connection of the conductive ink (102; 202; 302),
wherein the step of direct writing further includes forming a conformal layer of bus bar (104; 204; 304) on the conductive ink (102; 202; 302).

2. A method as recited in claim 1, further including soldering a wire (108; 208; 308) to the bus bar (104; 204; 304) to electrically connect the wire to the conductive ink (102; 202; 302).

3. A method as recited in claim 1 or 2, wherein the conductive ink (102; 202; 302) includes silver particles in an epoxy resin.

4. A method as recited in claim 1, 2, or 3, further including applying the conductive circuit to at least one panel skin (203) of an aircraft floor panel (200).

5. A method as recited in any preceding claim, wherein the bus bar (104; 204; 304) is a metal bus bar.

6. A method as recited in claim 5, wherein the metal bus bar (104; 204; 304) is a copper bus bar.

7. A method as recited in any of claims 1 to 6, wherein the bus bar (104; 204; 304) is an alloy bus bar.

## Patentansprüche

1. Verfahren zum Bereitstellen einer elektrischen Verbindung (107; 207; 307) für leitfähige Tinte, die auf einen dielektrischen Film (106; 206; 306) siebgedruckt wurde, um eine leitfähige Schaltung für eine Luftfahrzeugbodenplatte (200) zu erzeugen, wobei das Verfahren umfasst:
Direktschreiben einer Sammelschiene (104; 204; 304) auf Bereiche einer gewünschten elektrischen Verbindung der leitfähigen Tinte (102; 202; 302),
wobei der Schritt des Direktschreibens ferner das Bilden einer konformen Schicht der Sammelschiene (104; 204; 304) auf der leitfähigen Tinte (102; 202; 302) beinhaltet.

2. Verfahren nach Anspruch 1, ferner beinhaltend das Löten eines Drahtes (108; 208; 308) an die Sammelschiene (104; 204; 304), um den Draht elektrisch mit der leitfähigen Tinte (102; 202; 302) zu verbinden.

3. Verfahren nach Anspruch 1 oder 2, wobei die leitfähige Tinte (102; 202; 302) Silberpartikel in einem Epoxidharz beinhaltet.

4. Verfahren nach Anspruch 1, 2 oder 3, ferner beinhaltend das Aufbringen der leitfähigen Schaltung auf wenigstens eine Plattenhaut (203) einer Luftfahrzeugbodenplatte (200).

5. Verfahren nach einem der vorhergehenden Ansprüche, wobei die Sammelschiene (104; 204; 304) eine Metallsammelschiene ist.

6. Verfahren nach Anspruch 5, wobei die Metallsammelschiene (104; 204; 304) eine Kupfersammelschiene ist.

7. Verfahren nach einem der Ansprüche 1 bis 6, wobei die Sammelschiene (104; 204; 304) eine Legierungssammelschiene ist.

## Revendications

1. Procédé permettant d'établir une connexion électrique (107 ; 207 ; 307) pour une encre conductrice sérigraphiée sur un film diélectrique (106 ; 206 ; 306) afin de créer un circuit conducteur pour un panneau de plancher d'aéronef (200), le procédé comprenant :
l'écriture directe d'une barre de bus (104 ; 204 ; 304) sur des zones d'une connexion électrique souhaitée de l'encre conductrice (102 ; 202 ; 302),
dans lequel l'étape d'écriture directe comporte également la formation d'une couche conformale de barre de bus (104 ; 204 ; 304) sur l'encre conductrice (102 ; 202 ; 302).

2. Procédé selon la revendication 1, comportant également la soudure d'un fil (108 ; 208 ; 308) à la barre de bus (104 ; 204 ; 304) pour connecter électriquement le fil à l'encre conductrice (102 ; 202 ; 302).

3. Procédé selon la revendication 1 ou 2, dans lequel l'encre conductrice (102 ; 202 ; 302) comporte des particules d'argent dans une résine époxy.

4. Procédé selon la revendication 1, 2 ou 3, comportant également l'application du circuit conducteur à au moins un revêtement de panneau (203) d'un panneau de plancher d'aéronef (200).

5. Procédé selon une quelconque revendication précédente, dans lequel la barre de bus (104 ; 204 ; 304) est une barre de bus métallique.

6. Procédé selon la revendication 5, dans lequel la barre de bus métallique (104 ; 204 ; 304) est une barre de bus en cuivre.

7. Procédé selon l'une quelconque des revendications 1 à 6, dans lequel la barre de bus (104 ; 204 ; 304) est une barre de bus en alliage.
